(19)

(11) **EP 1 350 325 B1**

(12) **EUROPÄISCHE PATENTSCHRIFT**


(45) Veröffentlichungstag und Bekanntmachung des Hinweises auf die Patenterteilung:
**06.10.2010 Patentblatt 2010/40**

(21) Anmeldenummer: **01995564.0**

(22) Anmeldetag: **04.12.2001**

(51) Int Cl.:
***H03M 1/36*** (2006.01) ***H03M 1/06*** (2006.01)

(86) Internationale Anmeldenummer:
**PCT/DE2001/004539**

(87) Internationale Veröffentlichungsnummer:
**WO 2002/047273 (13.06.2002 Gazette 2002/24)**


(54) **ANALOG-DIGITAL-WANDLER UND VERFAHREN ZUR WANDLUNG EINES ANALOGSIGNALS IN EIN DIGITALSIGNAL**

ANALOG-TO-DIGITAL CONVERTER AND METHOD FOR CONVERTING AN ANALOG SIGNAL INTO A DIGITAL SIGNAL

CONVERTISSEUR ANALOGIQUE-NUMERIQUE ET PROCEDE DE CONVERSION D'UN SIGNAL ANALOGIQUE EN UN SIGNAL NUMERIQUE


(84) Benannte Vertragsstaaten:
**DE FR GB IT**

(30) Priorität: **04.12.2000 DE 10060159**

(43) Veröffentlichungstag der Anmeldung:
**08.10.2003 Patentblatt 2003/41**



(73) Patentinhaber: **Infineon Technologies AG**
**85579 Neubiberg (DE)**

(72) Erfinder: **PAULUS, Christian**
**81247 München (DE)**

(74) Vertreter: **Viering, Jentschura & Partner**
**Postfach 22 14 43**
**80504 München (DE)**



(56) Entgegenhaltungen:
**EP-A- 0 328 215 US-A- 4 395 732**
**US-A- 4 978 957 US-A- 4 983 968**
**US-A- 5 119 098 US-A- 6 072 416**

- **KRENIK W R ET AL: "Current-mode flash A/D conversion based on current-splitting techniques" PROCEEDINGS OF THE INTERNATIONAL SYMPOSIUM ON CIRCUITS AND SYSTEMS. SAN DIEGO, MAY 10 - 13, 1992, PROCEEDINGS OF THE INTERNATIONAL SYMPOSIUM ON CIRCUITS AND SYSTEMS. (ISCAS), NEW YORK, IEEE, US, Bd. 4 CONF. 25, 3. Mai 1992 (1992-05-03), Seiten 585-588, XP010061268 ISBN: 0-7803-0593-0**



Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).





Printed by Jouve, 75001 PARIS (FR)

## Beschreibung

Die Erfindung betrifft einen Analog-Digital-Wandler und ein Verfahren zur Wandlung eines Analogsignals in ein Digitalsignal.

Analog-Digital-Wandler (ADC = analog digital converter) werden nach dem Stand der Technik standardmäßig als integrierte Schaltung unter Ausnutzung von Metall-Oxyd-Halbleiterstrukturen und/oder bipolare Halbleiterstrukturen auf Halbleitersubstraten hergestellt. Bei hohen Anforderungen an die Signalverarbeitungsgeschwindigkeit wird häufig auf den sogenannten Flash-ADC zurückgegriffen.

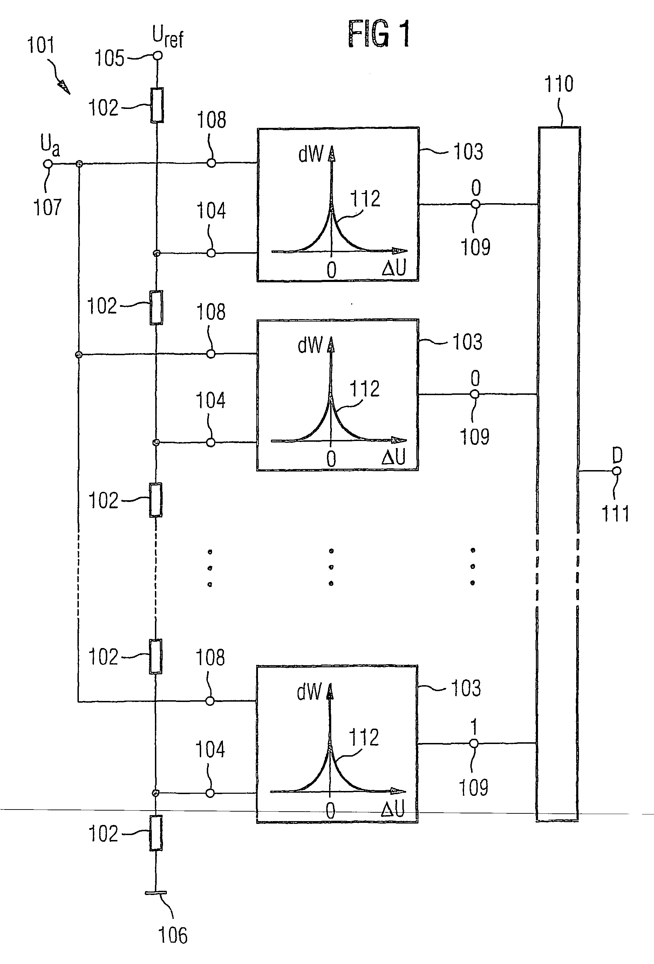

Wie in **Fig.1** gezeigt, ist ein Flash-ADC gemäß dem Stand der Technik ein Analog-Digital-Wandler 101, welcher als Referenznetzwerk beispielsweise eine Widerstandskaskade mit mehreren in Reihe geschalteten Widerständen 102 sowie mehrere Komparatoren 103 aufweist, wobei die Komparatoren 103 mit einem ersten Eingang 104 zwischen jeweils zwei benachbarte Widerstände 102 geschaltet sind. Es wird eine Referenzspannung $U_{ref}$ derart an die Widerstandskaskade zwischen Kaskadeneingang 105 und Masseanschluss 106 angelegt, dass die Referenzspannung $U_{ref}$ in Teilspannungen zwischen den Widerständen 102 abfällt. Diese Teilspannungen werden von jeweils einem der Komparatoren 103 ausgewertet. Zur deutlicheren Darstellung sind in **Fig.1** lediglich drei Komparatoren 103 gezeigt, jedoch kann der Flash-ADC jede beliebige Anzahl von Komparatoren 103 aufweisen.

Ein zu wandelndes Analogsignal, d.h. eine Analogspannung $U_a$, wird über einen Analogsignaleingang 107 parallel an einen zweiten Eingang 108 aller Komparatoren 103 angelegt. Die Komparatoren 103 vergleichen nun die am zweiten Eingang 108 anliegende Analogspannung $U_a$ mit der jeweils am ersten Eingang 104 anliegenden Teilspannung. Ist die an einem der Komparatoren 103 anliegende Analogspannung $U_a$ größer als die anliegende Teilspannung, so ist der Komparator 103 aktiviert und gibt an einem Ausgang 109 ein Bit-Signal aus, welches einem ersten Bit-Wert "1" entspricht, andernfalls entspricht das Bit-Signal einem zweiten Bit-Wert "0".

Eine digitale Auswerteeinheit 110 erzeugt schließlich entsprechend dem mit der höchsten Teilspannung aktivierten Komparator 103 ein digitales Ausgangssignal D und gibt dieses an einem Digitalsignalausgang 111 aus.

In **Fig.1** ist in jedem der Komparatoren 103 ein Diagramm 112 dargestellt, in dem eine Wahrscheinlichkeitsdichte dW gegenüber einer Spannungsdifferenz $\Delta U$ aufgetragen ist. dW bezeichnet dabei die Wahrscheinlichkeitsdichte, dass bei der angegebenen Eingangsdifferenzspannung $\Delta U$ am Ausgang 109 des jeweiligen Komparators 103 ein Übergang von einem ersten Bit-Wert "1" zu einem zweiten Bit-Wert "0" oder umgekehrt stattfindet. Ein idealer Komparator weist eine infinitesimal schmale Wahrscheinlichkeitsdichte dW auf, d.h. der Übergang von einem Bit-Wert zum anderen Bit-Wert findet exakt bei der Eingangsdifferenzspannung $\Delta U=0$ statt. Wegen statistischer Effekte weisen reale Komparatoren jedoch eine breite Wahrscheinlichkeitsdichte dW auf. Dies führt beispielsweise dazu, dass der Komparator 103 (nicht) aktiviert würde, obwohl eine Analogspannung $U_a$ anliegt, welche (größer) kleiner ist als die anliegende Teilspannung. Die im Diagramm 112 aufgetragene Spannungsdifferenz $\Delta U$ wird aus der anliegenden Teilspannung der Referenzspannung $U_{ref}$ und der anliegenden Analogspannung $U_a$ gebildet.

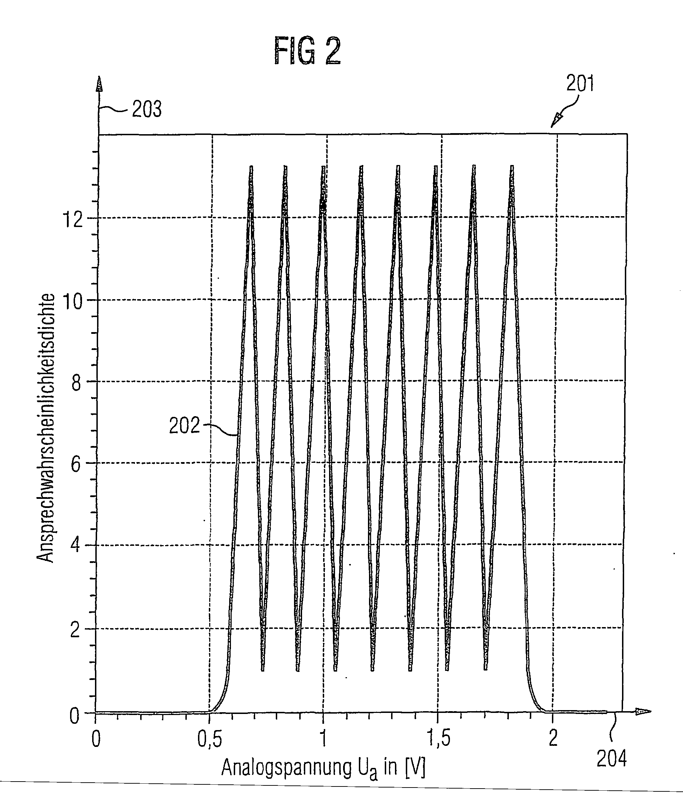

In **Fig.2** ist ein Diagramm 201 dargestellt, in dem ein Verlauf 202 der Ansprechwahrscheinlichkeitsdichte 203 von Komparatoren 103 des in **Fig.1** beschriebenen Flash-ADC gegenüber der anliegenden Analogspannung $U_a$ 204 aufgetragen ist. Das Diagramm 201 resultiert aus einer Kombination der einzelnen Wahrscheinlichkeitsdichten dW der Komparatoren 103, welche in **Fig.1** als Einzeldiagramme 112 in den Komparatoren 103 dargestellt sind.

Da jeder Komparator 103 einem anderen Teil der Referenzspannung $U_{ref}$ zugeordnet ist, ergibt sich der Verlauf 202 der Ansprechwahrscheinlichkeitsdichte 203 der Komparatoren 103 aus einer linearen Auftragung der einzelnen Wahrscheinlichkeitsdichten dW von benachbarten Komparatoren 103 in aufsteigender Richtung über der anliegenden Analogspannung $U_a$ 204. Aus den gegeneinander nahezu isolierten Wahrscheinlichkeitsdichten dW der einzelnen Komparatoren 103 folgt, dass die Übergänge der Komparatoren 103 sehr genau definiert sind und der Flash-ADC somit eine große Genauigkeit aufweist. Nach dem Stand der Technik werden Flash-ADCs mit Genauigkeiten von typischerweise 5 bis 6 Bit realisiert und unter anderem in den Lesezweigen von Festplatten verwendet.

Bei einem gängigen Analog-Digital-Wandler werden üblicherweise Widerstände zur Erzeugung der Referenzwerte verwendet, welche auf dem Halbleitersubstrat aus einem Halbleitermaterial gefertigt sind, wobei jeder entsprechende Widerstandswert durch die Anzahl der Atom-, Molekül- bzw. Kristallitgrenzen in dem Halbleitermaterial innerhalb der jeweiligen Widerstandsfläche A bestimmt ist.

Bei Reduzierung der Widerstandsfläche A sinkt die Atom-, Molekül- bzw. Kristallitanzahl im Halbleiterkristall und somit die Anzahl an Atom-, Molekül- bzw. Kristallitgrenzen, wodurch die Standardabweichung des dieser Widerstandsfläche A entsprechenden Widerstandswertes um den Faktor $\left(\sqrt{A}\right)^{-1}$ zunimmt. Bei abnehmender Widerstandsfläche A steigt also die Wahrscheinlichkeit W, dass ein Komparator aktiviert ist und ein falsches Bit-Signal ausgibt, obwohl eine Analogspannung $U_a$ anliegt, welche kleiner ist als die am betreffenden Komparator anliegende Sollteilspannung des Referenznetzwerkes.

Die Genauigkeit eines derartigen Analog-Digital-Wandlers wird weiterhin durch die statistischen Schwankungen der Transistorparameter bestimmt. Beispielsweise nimmt die Variation der Schwellenspannung eines MOS-Transistors ebenfalls mit zunehmender Fläche des Transistors mit dem Faktor $\left(\sqrt{A}\right)^{-1}$ ab. Diese Parametervariation in den Transistoren des Komparators führt zur sogenannten Eingangsoffsetspannung, so dass ein Komparator nicht bei einer Eingangsspannungsdifferenz $\Delta U$ von exakt $\Delta U=0$ umschlägt, sondern bei einer Eingangsspannungsdifferenz $\Delta U$, die dem individuellen Komparatoroffset entspricht.

Diese statistischen Variationen begrenzen die Linearität des gesamten Analog-Digital-Wandlersystems, weshalb beim Design auf ausreichende Bauteilflächen geachtet werden muss, um die Genauigkeitsanforderungen zu erfüllen.

Weisen die einzelnen Komparatoren eine ausreichende Genauigkeit auf, so weist eine Kette von Komparatoren, welche in der oben beschriebenen Weise mit einem Widerstandsnetzwerk verbunden sind, ein Ausgangssignal auf, das als Thermometercode bekannt ist. Dies bedeutet, dass alle Komparatoren, deren erster Eingang mit einer Teilspannung der Referenzspannung $U_{ref}$ verbunden ist, die kleiner ist als die am zweiten Eingang anliegende Analogspannung $U_a$, den Bit-Wert "1" ausgeben, wohingegen alle weiteren Komparatoren den Bit-Wert "0" ausgeben. Derartige Ausgangssignale können dann besonders einfach in ein digitales Ausgangswort umgesetzt werden. Üblicherweise wird zwischen einem Thermometer-Binär-Kodierer und den Ausgängen der Komparatoren noch eine Korrekturlogik geschaltet, die sogenannte "bubbles" im Thermometercode (eine "0" zwischen mehreren "1" und umgekehrt) eliminieren um eine zuverlässige Binärkodierung zu ermöglichen.

Das oben im Zusammenhang mit den Flash-ADCs beschriebene Widerstandsnetzwerk dient zur Bereitstellung der Referenz-Teilspannungen, mit denen eine analoge Eingangsspannung $U_a$ in den Komparatoren verglichen wird. Alternativ zu den Widerstandsnetzwerken kann auch jedes andere Referenzsignalnetzwerk verwendet werden. So können beispielsweise auch Stromquellen mit unterschiedlichen Ausgangsströmen als Referenzsignal herangezogen werden. Als informationstragende Größe können also nicht nur Spannungen verwendet werden, sondern es sind auch sogenannte "currentmode" Lösungen möglich, bei denen die Information durch Ströme repräsentiert wird.

Im Gegensatz zu den Parametervariationen nehmen die parasitären Kapazitäten, welche bei größeren Bauteilflächen entstehen und generell unerwünscht sind, mit zunehmender Bauteilfläche A zu. Dadurch nimmt jedoch die Signalverarbeitungsgeschwindigkeit ab. Dies bedeutet folglich, dass bei einem gängigen Analog-Digital-Wandler eine hohe Genauigkeit zu Lasten der Signalverarbeitungsgeschwindigkeit geht. Nach dem Stand der Technik werden Flash-Wandler in CMOS-Technologie mit Umsetzraten bis zu 1 GSa/s (Giga-Samples pro Sekunde = $10^9$ Abtastungen pro Sekunde) bei einer Genauigkeit von 6 Bit realisiert.

Ferner ist in [1] ein Analog-/Digital-Wandler beschrieben mit einem Referenznetzwerk, einer Vielzahl von Komparatoren sowie einer Interpolationseinheit. Die Interpolationseinheit besteht aus einer Vielzahl zusätzlicher Komparatoren, denen die Ausgangssignale der Komparatoren einer ersten Stufe, welche unmittelbar an das Referenznetzwerk angeschlossen sind, nach erfolgter Gewichtung der Ausgangssignale zugeführt werden. Die zusätzlichen Komparatoren dienen somit als Interpolationseinheit zur Interpolation der von den Komparatoren der ersten Stufe bereitgestellten Signale.

Das in [1] beschriebene Interpolationsnetzwerk dient lediglich zum Umcodieren der Information aus dem Thermometercode in den Binärcode, wobei durchgängig eine deterministische Signalverarbeitung erfolgt.

Ein anderer Analog-/Digital-Wandler mit einem Interpolationsnetzwerk ist in [2] beschrieben.

In EP 328 215 wird ein ADC beschrieben, bei dem eine hybride Logik mit den Ausgängen aller Komparatoren gekoppelt ist, wobei mit der hybriden Logik aus den digital Ausgangssignalen aller Komparatoren ein korrigierter Digitalwert gebildet wird.

US 4983968 beschreibt einen ADC, bei dem eine Korrekturstufe in Serie mit einer Komparatorstufe geschaltet ist. Mittels der Korrekturstufe wird in dem Fall, dass ein Komparator der Komparatorstufe einen logischen Wert ausgibt, welcher von denjenigen der beiden benachbarter Komparatoren abweicht, die Ausgabe dieses Komparators auf den Wert der beiden Nachbarkomparatoren gesetzt, falls deren Werte identisch sind. Hierdurch erfolgt eine lokale Fehlerkorrektur.

Der Erfindung liegt somit das Problem zugrunde, einen Analog-Digital-Wandler sowie ein Verfahren zur Wandlung eines Analogsignals in ein Digitalsignal anzugeben, mit dem trotz kleiner Bauteilgröße eine hohe Genauigkeit bzw. Linearität des Wandlers erreicht werden kann.

Das Problem wird durch einen Analog-Digital-Wandler sowie durch ein Verfahren zur Wandlung eines Analogsignals in ein Digitalsignal mit den Merkmalen gemäß den unabhängigen Patentansprüchen gelöst.

Ein Analog-Digital-Wandler weist mehrere Komparatoren und ein Referenznetzwerk auf, wobei das Referenznetzwerk mehrere Referenzelemente aufweist. Zwischen jedem Referenzelement in dem Referenznetzwerk des Analog-Digital-Wandlers ist mindestens ein Eingang mindestens eines Komparators angeschlossen. An die Ausgänge der Komparatoren des Analog-Digital-Wandlers ist eine digitale Auswerteschaltung gekoppelt, mit der eine statistische Bearbeitung von durch die Komparatoren erzeugten Ausgangssignalen erfolgen kann.

Bei einem Verfahren zum Umwandeln eines Analogsignals in ein Digitalsignal werden ein Referenzsignal an ein Referenznetzwerk mit mehreren Referenzelementen und ein Analogsignal an mindestens einen Eingang mehrerer Komparatoren angelegt. Die Komparatoren, die mit mindestens einem weiteren Eingang an das Referenznetzwerk geschaltet sind, bilden bei diesem Verfahren mehrere digitale Ausgangssignale, welche anschließend statistisch bearbeitet werden. Bei dem erfindungsgemäßen Verfahren wird schließlich noch aus den statistisch bearbeiteten Ausgangssignalen ein gemeinsames Digitalsignal gebildet.

Ein Vorteil der Erfindung kann anschaulich darin gesehen werden, dass das Problem des Bauteilmismatchs berücksichtigt wird indem mit Hilfe einer einfachen Schaltung sehr früh im analogen Signalpfad eine - fehlerbehaftete - Quantisierung stattfindet und anschließend eine statistische Bearbeitung im digitalen Teil des Analog-Digital-Wandlers erfolgt. Hierzu wird anschaulich eine große Zahl von Komparatoren mit sehr kleinen Bauteilflächen und folglich schlechter Genauigkeit verwendet und deren digitalen Ausgänge mit einer geeigneten Logik abgezählt und dadurch beispielsweise gemittelt.

Ein weiterer Vorteil des erfindungsgemäßen Analog-Digital-Wandlers ist die Tauglichkeit für sehr kleine Betriebsspannungen. Da der Anteil der analogen Bauteile am erfindungsgemäßen Analog-Digital-Wandler sehr klein ist und die analogen Bauteile weiterhin sehr einfach ausfallen, kann das Verhältnis von Betriebsspannung zu Schwellenspannung, ab der z.B. ein Übergang in einem Komparator detektiert werden kann, sehr gering gehalten werden. Dadurch ist der erfindungsgemäße Analog-Digital-Wandler auch für einen Einsatz in neuen integrierten Schaltungen mit geringer Betriebsspannung geeignet.

Schließlich ergibt sich noch als weiterer Vorteil, dass der digitale Anteil des erfindungsgemäßen Analog-Digital-Wandlers durch ein programmgesteuertes Aktivieren von bestehenden integrierten Schaltungen weitgehend automatisch hergestellt werden kann (VHDL = very high speed IC hardware description language). Dadurch werden der Designaufwand, und damit der Herstellungsaufwand, sowie die Herstellungskosten deutlich reduziert. Außerdem wird eine einfache Portierbarkeit auf neue Technologien gewährleistet.

Als Referenznetzwerk wird der Einsatz eines Widerstandsnetzwerks, eines Stromquellennetzwerks oder eines kapazitiven Netzwerks bevorzugt. Als Referenzelemente werden dann Widerstände, Stromquellen oder Kondensatoren eingesetzt.

Vorzugsweise ist die digitale Auswerteschaltung des erfindungsgemäßen Analog-Digital-Wandlers derart eingerichtet, dass im Rahmen der statistischen Bearbeitung der Ausgangssignale eine statistische Mittelwertbildung erfolgen kann.

Alternativ könnte die statistische Bearbeitung auch eine Filterung der Ausgangssignale zur Ausblendung von digitalen Ausreißer-Ausgangssignalen, eine Wichtung der Ausgangssignale relativ zum Zentrum eines Ausgangssignal-Clusters oder jede weitere Art der statistischen Signalverarbeitung beinhalten. Ein Vorteil der statistischen Bearbeitung ist die Verbesserung der Genauigkeit des Analog-Digital-Wandlers.

In einer bevorzugten Weiterbildung des erfindungsgemäßen Analog-Digital-Wandlers ist zwischen jedes Referenzelement des Referenznetzwerks eine Mehrzahl von Komparatoren parallel geschaltet sowie die digitale Auswerteschaltung derart eingerichtet, dass im Rahmen der statistischen Bearbeitung die von parallelen Komparatoren erzeugten Ausgangssignale gemittelt werden können und daraus ein gemeinsames Ausgangssignal gebildet werden kann.

In einer weiteren bevorzugten Weiterbildung des erfindungsgemäßen Analog-Digital-Wandlers ist zwischen jedes Referenzelement des Referenznetzwerks ein Komparator mit mehreren Ausgängen geschaltet, welche bei unterschiedlichen Eingangsdifferenzspannungen aktiviert werden. Die digitale Auswerteschaltung ist derart eingerichtet, dass im Rahmen der statistischen Bearbeitung die von den Komparatoren erzeugten Ausgangssignale gemittelt werden können und daraus ein gemeinsames Ausgangssignal gebildet werden kann.

In einer anderen bevorzugten Weiterbildung des erfindungsgemäßen Analog-Digital-Wandlers ist eine Mehrzahl von Komparatoren in mehrere Gruppen gruppiert sowie die digitale Auswerteschaltung derart eingerichtet, dass im Rahmen der statistischen Bearbeitung die von den Komparatoren jeweils einer Gruppe erzeugten Ausgangssignale gemittelt werden können und daraus ein gemeinsames Ausgangssignal gebildet werden kann.

In einer bevorzugten Weiterbildung des erfindungsgemäßen Analog-Digital-Wandlers wird eine volldifferentielle Signalverarbeitung verwendet. Die analoge Eingangsspannung $U_a$ sowie die Referenzspannung $U_{ref}$ liegen als differentielle Signale vor und werden in Komparatoren mit wenigstens zwei Referenzsignaleingängen und wenigstens zwei Messsignaleingängen ausgewertet.

Bei dem erfindungsgemäßen Verfahren werden die digitalen Ausgangssignale vorzugsweise in mehrere Signalgruppen mit mehreren digitalen Ausgangssignalen gruppiert. Dementsprechend wird die statistische Bearbeitung der digitalen Ausgangssignale innerhalb der jeweiligen Signalgruppe durchgeführt.

Vorzugsweise wird bei dem erfindungsgemäßen Verfahren als statistische Bearbeitung eine statistische Mittelwertbildung der digitalen Ausgangssignale durchgeführt. Dies kann beispielsweise durch einen 1-Bit-Addierer mit n Eingängen realisiert werden, wenn n Ausgänge von Komparatoren zur Verfügung stehen. Bei 255 Addierer-Eingängen, die jeweils den Bit-Wert "0" oder "1" annehmen können, führt dies zu einem 8 Bit breiten Ausgangswort.

Ausführungsbeispiele der Erfindung sind in den Figuren dargestellt und werden im folgenden näher erläutert. Dabei bezeichnen gleiche Bezugszeichen gleiche Komponenten.

Es zeigen

Figur 1 einen Analog-Digital-Wandler gemäß dem Stand der Technik;

Figur 2 ein Diagramm der relativen Ansprechwahrscheinlichkeit von Komparatoren des Analog-Digital-Wandlers aus Figur 1;

Figur 3 einen Analog-Digital-Wandler gemäß einem ersten Ausführungsbeispiel der Erfindung;

Figur 4 einen Analog-Digital-Wandler gemäß einem zweiten Ausführungsbeispiel der Erfindung; und

Figur 5 ein Diagramm der relativen Ansprechwahrscheinlichkeit von Komparatoren eines Analog-Digital-Wandlers gemäß einem Ausführungsbeispiel der Erfindung.

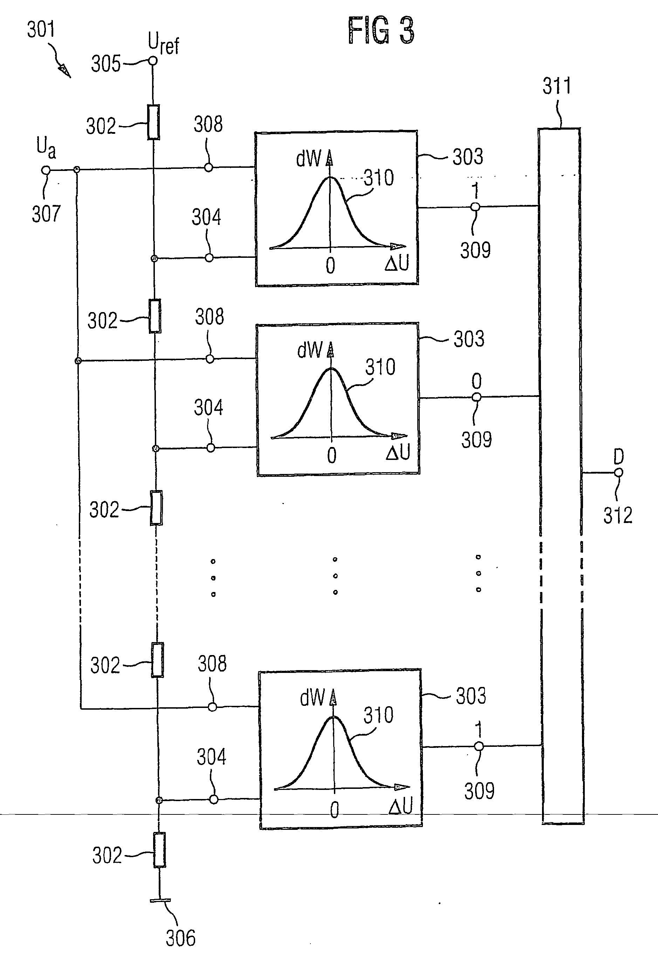

**Fig.3** zeigt einen Analog-Digital-Wandler 301 gemäß einem ersten Ausführungsbeispiel der Erfindung, welcher als Referenznetzwerk eine Widerstandskaskade mit mehreren in Reihe geschalteten Widerständen 302 als Referenzelemente sowie mehrere Komparatoren 303 aufweist, wobei die Komparatoren 303 mit einem ersten Eingang 304 jeweils zwischen zwei benachbarte elektrische Widerstände 302 geschaltet sind.

Im erfindungsgemäßen Analog-Digital-Wandler 301 werden Bauteile eingesetzt, welche wegen ihrer geringen Größe eine große Signalverarbeitungsgeschwindigkeit aufweisen aber damit eher ungenau sind. Durch die geringe Bauteilgröße haben die elektrischen Widerstände 302 sowie die in den Komparatoren 303 enthaltenen integrierten Bauteile folglich eine geringe aktive Bauteilfläche A. In einer 0,13 $\mu$m CMOS-Technologie beispielsweise bedeutet dies, dass ein einzelner MOS-Transistor eine aktive Fläche von etwa (0,13 x 0,13) $\mu m^2$ = 0,017 $\mu m^2$ aufweist, was zu Variationen in der Schwellenspannung benachbarter MOS-Transistoren bis zu mehreren 10 mV führen kann. Wird wegen der Geschwindigkeitsanforderungen von sehr einfachen Komparatoren ausgegangen, so bestehen die Komparatoren aus typischerweise sechs bis acht Transistoren und weisen aufgrund der geringen Bauteilgrößen einen Eingangsoffset von mehreren 10 mV auf. In einer derartigen Technologie können Umsetzraten von mehreren GSa/s erzielt werden.

Es wird eine Referenzspannung $U_{ref}$ derart an die Widerstandskaskade zwischen Kaskadeneingang 305 und Masseanschluss 306 angelegt, dass die Referenzspannung $U_{ref}$ in Teilspannungen zwischen den Widerständen 302 abfällt. Im Vergleich mit dem Stand der Technik verwendet dieses Ausführungsbeispiel der Erfindung bei gleicher Auflösung jedoch eine Anzahl von Widerständen 302 und Komparatoren 303, welche mindestens genauso groß ist, bevorzugt mindestens doppelt so groß. Das bedeutet, dass ein im Stand der Technik gebildeter Teilspannungsbereich, der durch einen einzigen der Widerstände 102 erzeugt wurde, gemäß dem Ausführungsbeispiel der Erfindung durch die Widerstände 302 in mindestens zwei Teilspannungsbereiche aufgeteilt wird. Diese Teilspannungsbereiche werden von jeweils einem der Komparatoren 303 ausgewertet.

Ein zu wandelndes Analogsignal, d.h. eine Analogspannung $U_a$, wird über einen Analogsignaleingang 307 parallel an einen zweiten Eingang 308 aller Komparatoren 303 angelegt. Die Komparatoren 303 dienen dem Vergleich der am zweiten Eingang 308 anliegenden Analogspannung $U_a$ mit der am ersten Eingang 304 anliegenden Teilspannung. Ist die an einem der Komparatoren 303 anliegende Analogspannung $U_a$ größer als die anliegende Teilspannung, so sollte der Komparator 303 aktiviert sein und an einem Ausgang 309 ein Bit-Signal ausgeben, welches einem ersten Bit-Wert "1" entspricht, andernfalls entspricht das Bit-Signal einem zweiten Bit-Wert "0".

Die Genauigkeit der Komparatoren 303 ist bei gleicher Auflösung aufgrund der geringen aktiven Bauteilfläche A gering. Die Komparatoren 303 geben deshalb mit der Wahrscheinlichkeit W einen falschen Bit-Wert aus, d.h. der ausgegebene Bit-Wert entspricht nicht den tatsächlichen Werten der anliegenden Teilspannung und der anliegenden Analogspannung $U_a$. Die Wahrscheinlichkeitsdichte dW ist für jeden der Komparatoren 303 in den Diagrammen 310 in den Komparatoren 303 gegenüber der Spannungsdifferenz $\Delta U$ zwischen anliegender Teilspannung und anliegender Analogspannung $U_a$ aufgetragen. Die Eingangsoffsetspannung der Komparatoren kann bei Verwendung von sogenannten Minimalbauteilen, d.h. Bauteilen mit minimalen technologiespezifischen Dimensionen, bis zu mehreren 10 mV betragen.

Eine digitale Auswerteeinheit 311 dient dem Auslesen der von den Komparatoren 303 erzeugten Bit-Werte, dem Erzeugen eines digitalen Ausgangssignals D nach Durchführen einer statistischen Bearbeitung der Bit-Werte und der Ausgabe des digitalen Ausgangssignals D an einem Digitalsignalausgang 312. Zur deutlicheren Darstellung sind in **Fig.3** lediglich drei Komparatoren 303 gezeigt, jedoch kann der Analog-Digital-Wandler 301 gemäß dem ersten Ausführungsbeispiel der Erfindung jede beliebige Anzahl von Komparatoren 303 aufweisen.

Die digitale Auswerteeinheit 304 führt bei der statistischen Bearbeitung der Bit-Werte vor allem eine Mittelung über mehrere Bit-Werte durch. Gemittelt werden dabei die Bit-Werte von Komparatoren 303, deren Teilspannungsbereiche zusammengenommen einen im Stand der Technik gebildeten Teilspannungsbereich repräsentieren. Durch diese Mittelung wird eine Fehlerkorrektur erreicht, d.h. die Erzeugung eines falschen Digitalwertes D durch fehlerhafte Bit-Werte wird minimiert.

Die Ausgänge der Komparatoren 303 liefern aufgrund der starken Streuung der Bauteilparameter keinen idealen Thermometercode, sondern ein Ausgangssignal mit zahlreichen "bubbles". Wegen der Verarbeitung dieser digitalen Daten mittels der erfindungsgemäßen Auswerteeinheit 304 stören diese jedoch nicht die Funktionsweise des Gesamtsystems, sondern werden wie beschrieben gemittelt.

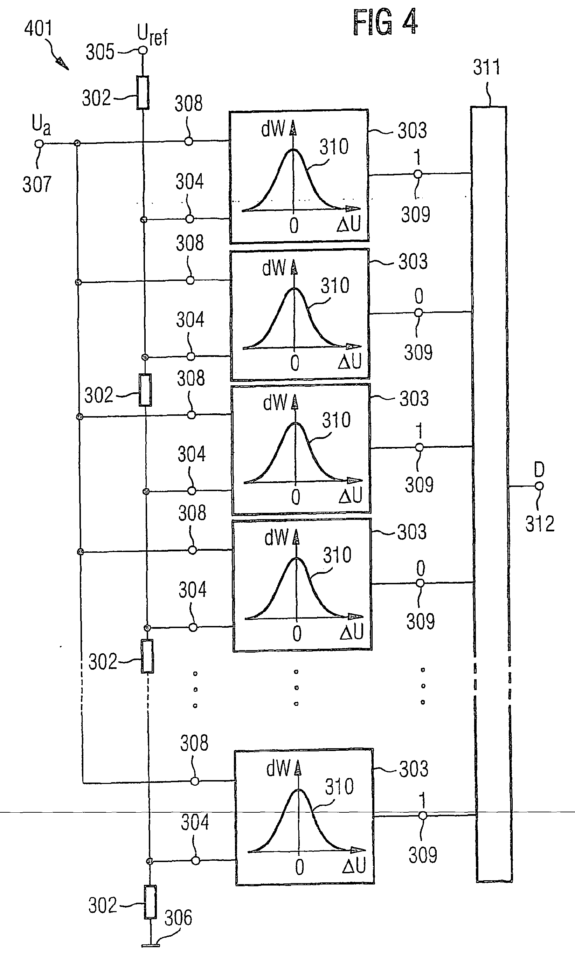

**Fig.4** zeigt einen Analog-Digital-Wandler 401 gemäß einem zweiten Ausführungsbeispiel der Erfindung, welcher als Referenznetzwerk eine Widerstandskaskade mit mehreren in Reihe geschalteten Widerständen 302 als Referenzelemente sowie mehrere Komparatoren 303 aufweist, wobei die Komparatoren 303 mit einem ersten Eingang 304 an die elektrischen Widerstände 302 gekoppelt sind.

Im Analog-Digital-Wandler 401 gemäß dem zweiten Ausführungsbeispiel der Erfindung werden wie beim Analog-Digital-Wandler 301 aus Fig.3 Komparatoren 303 eingesetzt, welche wegen ihrer geringen aktiven Bauteilfläche A eine große Signalverarbeitungsgeschwindigkeit aufweisen und damit eher ungenau sind.

Es wird eine Referenzspannung $U_{ref}$ derart an die Widerstandskaskade zwischen Kaskadeneingang 305 und Masseanschluss 306 angelegt, dass die Referenzspannung $U_{ref}$ in Teilspannungen zwischen den Widerständen 302 abfällt. Diese Teilspannungen werden in diesem Ausführungsbeispiel der Erfindung jeweils von mehreren Komparatoren 303 parallel ausgewertet. Im Vergleich mit dem Stand der Technik verwendet das zweite Ausführungsbeispiel der Erfindung bei gleicher Auflösung somit eine Anzahl von Komparatoren 303, die mindestens doppelt so groß ist.

Auch in **Fig.4** wird ein zu wandelndes Analogsignal, d.h. eine Analogspannung $U_a$, über einen Analogsignaleingang 307 parallel an einen zweiten Eingang 308 aller Komparatoren 303 angelegt. Die Komparatoren 303 dienen wiederum dem Vergleich der am zweiten Eingang 308 anliegenden Analogspannung $U_a$ mit der jeweils am ersten Eingang 304 anliegenden Teilspannung. Unter Berücksichtigung ihrer Ungenauigkeit geben die Komparatoren 303 entsprechend der anliegenden Analogspannung $U_a$ sowie der anliegenden Teilspannung ein Bit-Signal aus.

Die Wahrscheinlichkeitsdichte dW, dass die Komparatoren 303 bei einer bestimmten Eingangsspannung $\Delta U$ den logischen Zustand ihres Ausgangs ändern, ist für jeden der Komparatoren 303 in den Diagrammen 310 in den Komparatoren 303 gegenüber der Spannungsdifferenz $\Delta U$ zwischen anliegender Teilspannung und anliegender Analogspannung $U_a$ aufgetragen.

Die digitale Auswerteeinheit 311 dient dem Auslesen der von den Komparatoren 303 erzeugten Bit-Werte, dem Erzeugen eines digitalen Ausgangssignals D nach Durchführen einer statistischen Bearbeitung der Bit-Werte und der Ausgabe des digitalen Ausgangssignals D an einem Digitalsignalausgang 312. Zur deutlicheren Darstellung sind in **Fig.4** lediglich fünf Komparatoren 303 gezeigt, wobei jeweils zwei Komparatoren 303 die selbe Teilspannung am entsprechenden Widerstand 302 abgreifen, jedoch kann der Analog-Digital-Wandler 301 gemäß dem zweiten Ausführungsbeispiel der Erfindung jede beliebige Anzahl von Komparatoren 303 aufweisen.

Ein Kennzeichen des zweiten Ausführungsbeispiels der Erfindung ist, dass die ersten Eingänge 304 jeweils zweier Komparatoren 303 zwischen zwei benachbarte Widerstände 302 geschaltet sind und somit dasselbe elektrische Potential aufweisen.

Die digitale Auswerteeinheit 311 führt auch hier bei der statistischen Bearbeitung der Bit-Werte vor allem eine Mittelung über mehrere Bit-Werte durch. Gemittelt werden dabei die Bit-Werte von Komparatoren 303, welche den gleichen Teilspannungsbereich abgreifen. Durch diese Mittelung wird wiederum eine Fehlerkorrektur erreicht, d.h. die Erzeugung eines falschen Digitalwertes D durch fehlerhafte Bit-Werte wird minimiert.

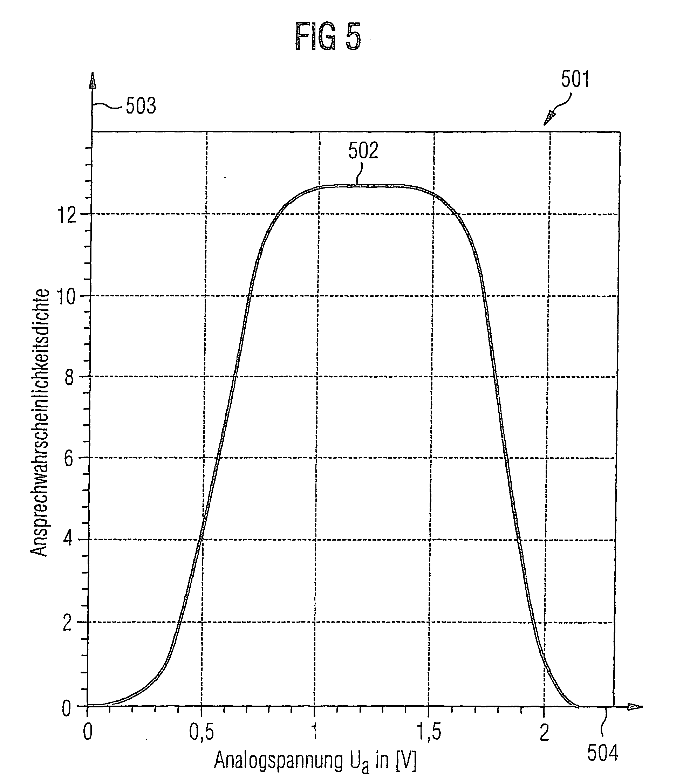

In **Fig.5** ist ein Diagramm 501 dargestellt, in dem ein Verlauf 502 der Ansprechwahrscheinlichkeitsdichte 503 von Komparatoren 303 der in den beiden Ausführungsbeispielen der Erfindung beschriebenen Analog-Digital-Wandler 301, 401 gegenüber der anliegenden Analogspannung $U_a$ 504 aufgetragen ist. Das Diagramm 501 resultiert aus einer Kombination der einzelnen Wahrscheinlichkeitsdichten dW der Komparatoren 303, welche in den **Fig.3** und **Fig.4** als Einzeldiagramme 310 in den Komparatoren 303 dargestellt sind (vgl. **Fig. 2**).

Der Verlauf 502 der Ansprechwahrscheinlichkeitsdichte 503 der Komparatoren 303 ergibt sich als überlappende Wahrscheinlichkeitsdichte dW der Komparatoren 303. Aus der überlappenden Wahrscheinlichkeitsdichte dW der Komparatoren 303 folgt, dass die Komparatoren 303 aufgrund großer statistisch verteilter Eingangsoffsetspannungen nicht zwingend einen Thermometercode ausgeben und somit eine spezielle Verarbeitungslogik für die digitalen Ausgangssignale notwendig ist. Die abnehmende Wahrscheinlichkeitsdichte dW an den Randbereichen des Spannungsintervalls, die dort die Linearität des Analog-Digital-Wandlers beeinträchtigen würde, kann mittels einer digitalen Korrekturfunktion im Digitalteil des Analog-Digital-Wandlers berücksichtigt werden.

Im Vergleich zum Stand der Technik wird in allen Ausführungsbeispielen der Erfindung anschaulich ein einziger großer Komparator, welcher genau aber langsam Signale verarbeitet, durch mehrere kleine Komparatoren ersetzt, welche ungenauer aber schneller Signale verarbeiten. Die digitale Auswerteeinheit 311 gewährleistet durch die statistische Bearbeitung der Bit-Werte eine große Genauigkeit bei der Umsetzung eines Analogsignals in ein Digitalsignal D. Die Mittelung über mehrere kleine Komparatoren auf digitaler Seite entspricht also einem einzigen großen Komparator mit großer Signalverarbeitungsgeschwindigkeit.

Somit stellt die Erfindung einen Analog-Digital-Wandler 301 oder 401 zur Verfügung, welcher verglichen mit dem bekannten Analog-Digital-Wandler 101 bei gleicher Auflösung eine um einen bestimmten Faktor erhöhte Signalverarbeitungsgeschwindigkeit aufweist. Dieser Faktor liegt bei mindestens 1,5 bis 10.

In diesem Dokument sind folgende Veröffentlichungen zitiert:

[1] US 5,420,587
[2] US 5,291,198
[3] EP 328 215
[4] US 4,983,968

**Bezugszeichenliste**

| | |
|---|---|
| 101 | Analog-Digital-Wandler gemäß Stand der Technik |
| 102 | Widerstand |
| 103 | Komparator |
| 104 | erster Eingang |
| 105 | Kaskadeneingang |
| 106 | Masseanschluss |
| 107 | Analogsignaleingang |
| 108 | zweiter Eingang |
| 109 | Ausgang |
| 110 | digitale Auswerteeinheit |
| 111 | Digitalsignalausgang |
| 112 | Diagramm der Fehlerwahrscheinlichkeit |
| 201 | Diagramm der Ansprechwahrscheinlichkeitsdichte |
| 202 | Verlauf |
| 203 | Ansprechwahrscheinlichkeitsdichte |
| 204 | Analogspannung |
| 301 | Analog-Digital-Wandler gemäß erster Ausführungsform |
| 302 | Widerstand |
| 303 | Komparator |
| 304 | erster Eingang |
| 305 | Kaskadeneingang |
| 306 | Masseanschluss |
| 307 | Analogsignaleingang |
| 308 | zweiter Eingang |
| 309 | Ausgang |
| 310 | Diagramm der Fehlerwahrscheinlichkeit |
| 311 | digitale Auswerteeinheit |
| 312 | Digitalsignalausgang |
| 401 | Analog-Digital-Wandler gemäß zweiter Ausführungsform |
| 501 | Diagramm der Ansprechwahrscheinlichkeitsdichte |
| 502 | Verlauf |
| 503 | Ansprechwahrscheinlichkeitsdichte |
| 504 | Analogspannung |

**Patentansprüche**

1. Analog-Digital-Wandler (301) mit mehreren Komparatoren (303) und einem Referenznetzwerk, das mehrere Referenzelemente (302) aufweist,

   - bei dem zwischen jeweils zwei benachbarte Referenzelemente (302) des Referenznetzwerkes jeweils ein Eingang (304) eines Komparators (303) angeschlossen ist;
   - bei dem jeder Komparator (303) einen Ausgang (309) aufweist, an dem jeweils ein digitales Ausgangssignal bereitgestellt wird; und
   - bei dem eine digitale Logik (311) mit den Ausgängen (309) aller Komparatoren (303) gekoppelt ist, wobei mit der digitalen Logik (311) aus den digitalen Ausgangssignalen aller Komparatoren (303) ein gemeinsamer Mittelwert gebildet wird.

2. Analog-Digital-Wandler (301) gemäß Anspruch 1, bei dem als Referenznetzwerk ein Widerstandsnetzwerk, ein Stromquellennetzwerk oder ein kapazitives Netzwerk vorgesehen ist, wobei als Referenzelemente Widerstände, Stromquellen und/oder Kondensatoren eingesetzt werden.

3. Analog-Digital-Wandler (301) gemäß einem der Ansprüche 1 oder 2, wobei die digitale Logik (311) so eingerichtet ist, dass die digitalen Ausgangssignale aller Komparatoren (303) abgezählt werden können und **dadurch** der Mittelwert gebildet werden kann.

4. Analog-Digital-Wandler (301) gemäß Anspruch 3, wobei der Analog-Digital-Wandler (301) n Ausgänge (309) von Komparatoren (303) aufweist, und wobei die digitale Logik einen 1-Bit-Addierer mit n Eingängen aufweist, mit dessen Hilfe die Bildung des Mittelwerts aus den digitalen Ausgangssignalen erfolgt.

5. Verfahren zum Umwandeln eines Analogsignals ($U_a$) in ein Digitalsignal (D) mittels eines Analog-Digital-Wandlers (301) mit mehreren Komparatoren (303), welche jeweils einen ersten Eingang (304) und einen zweiten Eingang (308) sowie einen Ausgang (309) aufweisen, und einem Referenznetzwerk mit mehreren Referenzelementen (302), wobei zwischen jeweils zwei benachbarte Referenzelemente (302) jeweils ein erster Eingang (304) eines Komparators (303) angeschlossen ist,

   - bei dem ein Referenzsignal ($U_{ref}$) an das Referenznetzwerk mit den mehreren Referenzelementen (302) angelegt wird;
   - bei dem ein Analogsignal ($U_a$) an den zweiten Eingang (308) aller Komparatoren (303) angelegt wird;
   - bei dem jeder Komparator (303) jeweils ein digitales Ausgangssignal bildet und an seinem Ausgang (309) bereitstellt;
   - bei dem unter Verwendung einer digitalen Logik, welche mit den Ausgängen (309) aller Komparatoren (303) gekoppelt ist, aus den digitalen Ausgangssignalen aller Komparatoren (303) ein gemeinsamer Mittelwert gebildet wird; und
• bei dem ein gemeinsames Digitalsignal (D) gebildet wird.

**6.** Verfahren gemäß Anspruch 5,
bei dem die digitalen Ausgangssignale aller Komparatoren (303) mittels der digitalen Logik (311) abgezählt werden und **dadurch** der Mittelwert gebildet wird.

**7.** Verfahren gemäß einem der Ansprüche 5 oder 6,
bei dem das Bilden des Mittelwerts aus den digitalen Ausgangssignalen der Komparatoren (303) mit Hilfe eines 1-Bit-Addierers erfolgt.

## Claims

**1.** An analog/digital converter (301) having a plurality of comparators (303) and a reference network which has a plurality of reference elements (302),

• in which in each case an input (304) of a comparator (303) is respectively connected between two adjacent reference elements (302) of the reference network;
• in which each comparator (303) has an output (309), at which a digital output signal is respectively provided; and
• in which a digital logic (311) is coupled to the outputs (309) of all comparators (303), wherein a common mean is formed from the digital output signals of all comparators (303) by means of the digital logic (311).

**2.** The analog/digital converter (301) according to claim 1,
in which a resistor network, a current-source network or a capacitive network is provided as reference network, wherein resistors, current sources and/or capacitors are used as reference elements.

**3.** The analog/digital converter (301) according to one of claims 1 or 2,
wherein the digital logic (311) is set up such that the digital output signals of all comparators (303) may be counted and thereby the mean may be formed.

**4.** The analog/digital converter (301) according to claim 3,
wherein the analog/digital converter (301) has n outputs (309) of comparators (303), and wherein the digital logic has a 1-bit adder having n inputs by means of which the formation of the mean from the digital output signals is carried out.

**5.** A method for converting an analog signal ($U_a$) into a digital signal (D) by means of an analog/digital converter (301) having a plurality of comparators (303) which respectively have a first input (304) and a second input (308) as well as an output (309), and a reference network having a plurality of reference elements (302), wherein in each case a first input (304) of a comparator (303) is respectively connected between two adjacent reference elements (302),

• in which a reference signal ($U_{ref}$) is applied to the reference network having the plurality of reference elements (302);
• in which an analog signal ($U_a$) is applied to the second input (308) of all comparators (303);
• in which each comparator (303) respectively forms a digital output signal and provides the digital output signal at its output (309);
• in which a common mean is formed from the digital output signals of all comparators (303) using a digital logic which is coupled to the outputs (309) of all comparators (303); and
• in which a common digital signal (D) is formed.

**6.** The method according to claim 5,
in which the digital output signals of all comparators (303) are counted using the digital logic (311) and thereby the mean is formed.

**7.** The method according to one of claims 5 or 6, in which forming the mean from the digital output signals of the comparators (303) is carried out by means of a 1-bit adder.

## Revendications

**1.** Convertisseur (301) analogique-numérique comprenant tous les comparateurs (303) et un réseau de référence qui a plusieurs éléments (302) de référence,

• dans lequel respectivement l'entrée (304) d'un comparateur (303) est raccordée entre respectivement deux éléments (302) de référence voisins ;
• dans lequel chaque comparateur (303) a une sortie (309), à laquelle est disponible, respectivement, un signal numérique de sortie ; et
• dans lequel une logique (311) numérique est couplée aux sorties (309) de tous les comparateurs (303), une moyenne commune étant formée par la logique (311) numérique à partir des signaux numériques de sortie de tous les comparateurs (303).

**2.** Convertisseur (301) analogique-numérique suivant la revendication 1, dans lequel il est prévu comme réseau de référence un réseau de résistances, un réseau de sources de courant ou un réseau capacitif, en utilisant comme élément de référence, des résistances, des sources de courant et/ou des condensateurs.

**3.** Convertisseur (301) analogique-numérique suivant l'une des revendications 1 ou 2, dans lequel la logique (311) numérique est telle que les signaux numériques de sortie de tous les comparateurs (303) peuvent être comptés et qu'ainsi la moyenne peut être formée.

**4.** Convertisseur (301) analogique-numérique suivant la revendication 3, dans lequel le convertisseur (301) analogique-numérique a n sortie (309) de comparateurs (303) et dans lequel la logique numérique a un additionner à 1 bit ayant n entrées, à l'aide duquel la formation de la moyenne s'effectue à partir des signaux numériques de sortie.

**5.** Procédé de conversion d'un signal ($U_a$) analogique en un signal (D) numérique, au moyen d'un convertisseur (301) analogique-numérique ayant plusieurs comparateurs (303), qui ont respectivement une première entrée (304) et une deuxième entrée (308), ainsi qu'une sortie (309) et un réseau de référence ayant plusieurs éléments (302) de référence, respectivement une première entrée (304) d'un comparateur (303) étant raccordée entre respectivement deux éléments (302) de référence voisins ;

• dans lequel on applique un signal ($U_{ref}$) de référence au réseau de référence ayant les plusieurs éléments (302) de référence ;
• dans lequel on applique un signal ($U_a$) analogique à la deuxième entrée (308) de tous les comparateurs (303) ;
• dans lequel chaque comparateur (303) forme respectivement un signal numérique de sortie et le met à disposition à sa sortie (309) ;
• dans lequel, en utilisant une logique numérique, qui est couplée aux sorties (309) de tous les comparateurs (303), on forme une moyenne commune, à partir des signaux numériques de sortie de tous les comparateurs (303) ;
• dans lequel on forme un signal (D) numérique commun.

**6.** Procédé suivant la revendication 5, dans lequel on compte les signaux numériques de sortie de tous les comparateurs (303) au moyen de la logique (311) numérique et on forme ainsi la moyenne.

**7.** Procédé suivant l'une des revendications 5 ou 6, dans lequel on effectue la formation de la moyenne à partir des signaux numériques de sortie des comparateurs (303) à l'aide d'un additionneur à 1 bit.

FIG 1
101
105
$U_{ref}$
102
$U_a$
107
108
104
103
dW
112
0
ΔU
0
109
110
D
111
1
106

FIG 2
201
203
202
204
Ansprechwahrscheinlichkeitsdichte
0
2
4
6
8
10
12
0
0,5
1
1,5
2
Analogspannung $U_a$ in [V]

FIG 3
301
$U_{ref}$
305
302
308
$U_a$
307
304
303
dW
310
0
ΔU
1
309
311
0
D
312
306

FIG 4
401
305
$U_{ref}$
302
308
$U_a$
307
303
dW
310
1
304
309
0
ΔU
311
D
312
306

FIG 5
501
503
502
Ansprechwahrscheinlichkeitsdichte
12
10
8
6
4
2
0
0
0,5
1
1,5
2
504
Analogspannung $U_a$ in [V]

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- EP 328215 A
- US 4983968 A
- US 5420587 A
- US 5291198 A